Europäisches Patentamt

European Patent Office

Office européen des brevets

(11) Veröffentlichungsnummer: **0 237 844**
A1

# (12) EUROPÄISCHE PATENTANMELDUNG

(21) Anmeldenummer: **87102674.6**

(22) Anmeldetag: **25.02.87**

(51) Int. Cl.⁴: **H01L 21/00**

(30) Priorität: **18.03.86 CH 1091/86**

(43) Veröffentlichungstag der Anmeldung:
**23.09.87 Patentblatt 87/39**

(84) Benannte Vertragsstaaten:
**CH DE FR GB IT LI NL SE**

(71) Anmelder: **BBC Aktiengesellschaft Brown, Boveri & Cie.**
**Haselstrasse**
**CH-5401 Baden(CH)**

(72) Erfinder: **Gobrecht, Jens, Dr.**
**Brühlstrasse 37**
**CH-5412 Gebenstorf(CH)**
Erfinder: **Voboril, Jan**
**Landschreiberstrasse 2**
**CH-5415 Nussbaumen(CH)**

(54) **Verfahren zur Herstellung einer Abdeckschicht für die Halbleitertechnik sowie Verwendung der Abdeckschicht.**

(57) Eine Abdeckschicht (2) für die Halbleitertechnik mit einer Randkontur, die einen keilförmigen Querschnitt aufweist, wird durch überwiegend anisotropes Trockenätzen der Abdeckschicht (2) durch eine vor der Abdeckschicht (2) in einem endlichen Maskenabstand (A) angeordnete Maske (4) erzeugt.

Die auf diese Weise geätzte Abdeckschicht (2) eignet sich bersonders gut als isolierende Unterlage für eine Feldpltte im Randbereich eines an die Oberfläche tretenden P-N-Uebergangs sowie als Implantationsmaske zur Erzeugung eines P-N-Uebergangs mit lateralem Dotierungsgradienten.

FIG.2 C

EP 0 237 844 A1

## Verfahren zur Herstellung einer Abdeckschicht für die Halbleitertechnik sowie Verwendung der Abdeckschicht

Die vorliegende Erfindung betrifft ein Verfahren zur Herstellung einer Abdeckschicht für die Halbleitertechnik gemäss dem Oberbegriff des Anspruchs 1 sowie die Verwendung der nach diesem Verfahren hergestellten Abdeckschicht.

Bei nahezu allen Halbleiter-Bauelementen, deren Funktion auf der Wirkung von P-N-Uebergängen beruht, besteht das Problem, dass diese P-N-Uebergänge an irgendeiner Stelle den Rand des Halbleitersubstrats erreichen. Aus verschiedenen Gründen neigt dieser Randbereich zu elektrischen Durchbrüchen, falls der P-N-Uebergang in Sperrichtung gepolt ist.

Bei Leistungshalbleitern, die bezüglich der Sperrspannung üblicherweise hohen Anforderungen genügen müssen, ist es daher notwendig, das elektrische Feld am P-N-Uebergang auf der Oberfläche zu reduzieren, was gleichbedeutend ist mit einer Verbreiterung der zum P-N-Uebergang gehörenden Raumladungszone.

Als gebräuchlichste Methoden zur Verbreiterung der Raumladungszone haben sich durchgesetzt:

-die geometrische Modifikation des Randes des Bauelements in Form einer Abschrägung mit positivem oder negativem Winkel, in Form eines Grabens usw.

-die elektrische, interne Modifikation des Randgebietes in Form von Guard-Ringen, Feldplatten usw.

-eine Kombination beider Methoden.

Ein Ueberblick über diese bekannten Methoden zur Erhöhung der Sperrspannungsfestigkeit kann dem Artikel von P.A. Tove, J. Phys. D, 15 (1982), S. 517 ff. entnommen werden.

Die erstgenannte Methode der mechanischen Randbearbeitung hat gegenüber der internen, elektrischen Modifikation des Randbereichs den Nachteil, dass zum einen bestimmte Voraussetzungen an die Tiefe des P-N-Uebergangs gegeben sein müssen, und zum anderen die vergleichsweise groben, mechanischen Prozesse nur schlecht mit den übrigen Prozessen der Halbleitertechnologie kompatibel sind. Aus diesem Grunde ist es wünschenswert, eine entsprechend angepasste "elektronische" Randkonturierung bei der Herstellung der Bauelemente zur Verfügung zu haben.

Es ist nun vorgeschlagen worden (J. Tihanyi in IEDM Tech. Digest 1982, S. 6 ff.), das elektrische Feld im Randbereich eines an die Oberfläche tretenden P-N-Uebergangs durch eine schräg darüberliegende, durch eine SiO$_2$-Schicht isolierte Feldplatte aus Al zu beeinflussen. Für eine solche schräge Feldplatte ist eine SiO$_2$-Schicht mit einem keilförmigen Querschnitt nötig, auf welche die Feldplatte aufmetallisiert werden kann.

Diese Art der "elektronischen" Randkonturierung wird in der genannten Druckschrift zwar als sehr einfache und vollkommen stabile Struktur bezeichnet. Zugleich wird jedoch auf den grossen Nachteil aufmerksam gemacht, dass die Herstellung einer solchen schräg liegenden Struktur sehr schwierig sei.

Dieselbe Meinung wird auch in dem Artikel von P.A. Tove (S. 524 im Zusammenhang mit Fig. 11) vertreten, wo die Anschrägung der Oxidschicht als schwierig zu realisieren eingestuft wird.

Aufgabe der vorliegenden Erfindung ist es nun, ein Verfahren anzugeben, mit dem auf einfache Weise eine in der Halbleitertechnik, z.B. für eine schräg liegende Feldplatte, einsetzbare Abdeckschicht hergestellt werden kann, welche eine Randkontur mit einem keilförmigen Querschnitt aufweist.

Die Aufgabe wird durch die Merkmale des Anspruchs 1 gelöst. Der Kern der Erfindung besteht darin, für die Herstellung der Kontur mit keilförmigem Querschnitt ein überwiegend anisotrop wirkendes Trockenätzverfahren einzusetzen, das zugleich aber auch stets eine nicht verschwindende isotrope Komponente aufweist. Diese isotrope Komponente kommt in Form einer weitgehend keilförmigen Unterätzung dann zum Tragen, wenn die beim Aetzprozess verwendete Maske einen ausreichenden Maskenabstand von der zu ätzenden Abdeckschicht einhält.

Bevorzugt wird das Verfahren mittels eines Plasmaätzprozesses durchgeführt, dessen Prozessparameter so gewählt sind, dass die Aetzung überwiegend anisotrop abläuft.

Dicke und Material der Abdeckschicht, Maskenabstand und andere Grössen können in weiten Bereichen den jeweiligen Anforderungen an die resultierende Abdeckschicht angepasst werden. Bewährt hat sich ein Maskenabstand im Bereich von 1 bis 10 mm.

Die mit dem erfindungsgemässen Verfahren erzeugte konturierte Abdeckschicht lässt sich besonders gut als isolierende Unterlage (in Form einer SiO$_2$-Schicht) für eine schräg liegende Feldplatte im Randbereich eines planaren, hochsperrenden P-N-Uebergangs verwenden.

Eine weitere Verwendung betrifft die Erzeugung eines lateralen Dotierungsgradienten im Randbereich eines planaren, hochsperrenden P-N-Uebergangs. Ein solcher lateraler Dotierungsgradient wurde bisher durch Ionenimplantation mittels einer sehr kompliziert strukturierten Maske erzeugt (R. Stengl und U. Gösele, IEDM Tech. Digest, 1985, S. 154 ff.); er stellt ebenfalls eine Methode der "elektronischen" Randkonturierung eines Bauelements dar.

Die nach dem erfindungsgemässen Verfahren hergestellte Abdeckschicht mit abgeschrägtem Rand kann nun in diesem Ionenimplantationsverfahren in besonders einfacher Weise als Implantationsmaske Verwendung finden, wobei im Bereich des abgeschrägten Randes das erzeugte Dotierungsprofil kontinuierlich sich abflacht und so der gewünschte laterale Dotierungsgradient entsteht.

Die Erfindung soll nun nachfolgend im Zusammenhang mit der Zeichnung anhand von Ausführungsbeispielen näher erläutert werden. Es zeigen:

Fig. 1A-D: die wesentlichen Schritte bei der Strukturierung einer Abdeckschicht nach dem Stand der Technik;

Fig. 2A-D: die wesentlichen Schritte bei der Strukturierung einer Abdeckschicht gemäss einem bevorzugten Ausführungsbeispiel des erfindungsgemässen Verfahrens;

Fig. 3 die Verwendung einer nach dem erfindungsgemässen Verfahren hergestellten Abdeckschicht als isolierende Unterlage einer schräg liegenden Feldplatte;

Fig. 4 die Verwendung einer nach dem erfindungsgemässen Verfahren hergestellten Abdeckschicht als Implantationsmaske;

Fig. 5 das gemessene Tiefenprofil einer nach dem erfindungsgemässen Verfahren geätzten Abdeckschicht;

Fig. 6A ein zweites bevorzugtes Ausführungsbeispiel des erfindungsgemässen Verfahrens mit seitlicher Begrenzung der abgeschrägten Randkontur;

Fig. 6B die mit dem Verfahren nach Fig. 6A erzeugte Abdeckschicht mit seitlicher Begrenzung.

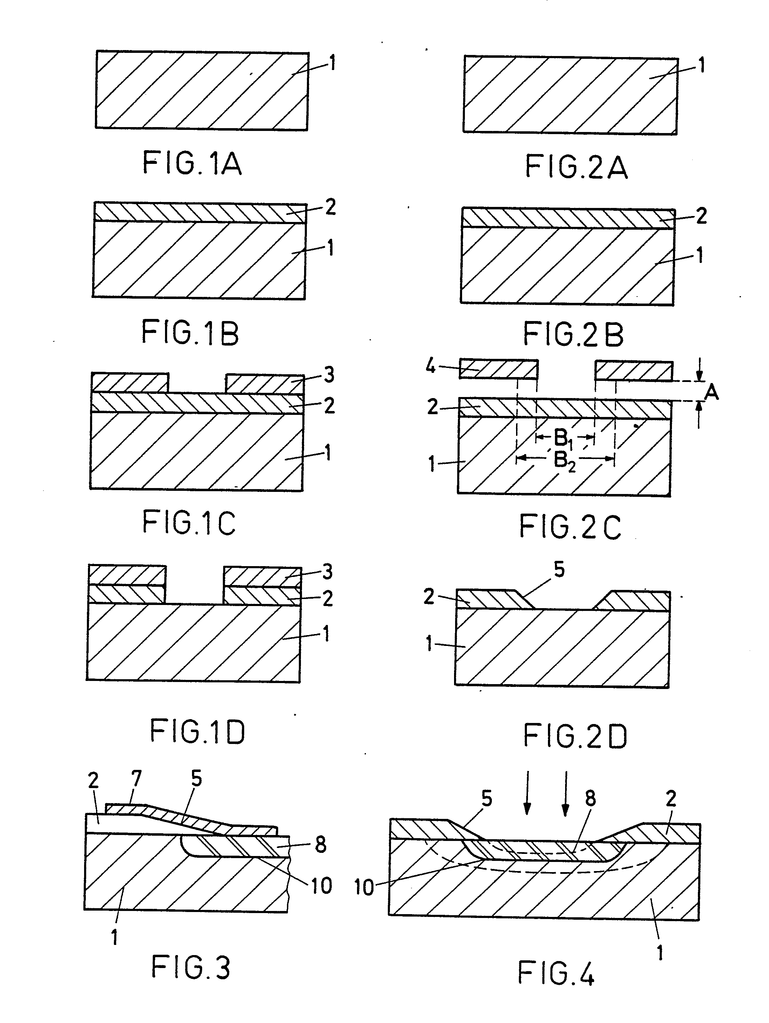

In der Figurenfolge Fig. 1A -1D sind die wesentlichen Schritte bei einem herkömmlichen Strukturierungsprozess für eine Abdeckschicht dargestellt. Ausgehend von einem Halbleitersubstrat 1 (Fig. 1A) wird auf eine Oberfläche dieses Substrats eine gleichmässige, durchgehende Abdeckschicht 2 (Fig. 1B), z.B. aus SiO₂, aufgebracht.

Ueber dieser Abdeckschicht 2 wird dann eine Maskenschicht 3 (Fig. 1C) aufgetragen, die beispielsweise aus Photolack besteht und durch Belichtung und Entwicklung in gewünschter Weise strukturiert ist. In einem nachfolgenden z.B. nasschemischen Aetzprozess wird dann die Abdeckschicht 2 an den Stellen abgetragen, die den Oeffnungen in der Maskenschicht 3 entsprechen (Fig. 1D).

Abgesehen von einer möglichen leichten Unterätzung unter den Rändern der Oeffnungen in der Maskenschicht 3, sind die Randkonturen der weggeätzten Bereiche in der Abdeckschicht weitgehend scharf und ungestört.

Im Unterschied zu dieser herkömmlichen Methode der Strukturierung von Abdeckschichten wird bei dem Verfahren nach der Erfindung der Abtragungsprozess gerade so gestaltet, dass die Randkonturen in der Abdeckschicht eine besondere Ausgestaltung, nämlich im wesentlichen einen keilförmigen Querschnitt, aufweisen. An die Stelle des herkömmlichen abrupten Uebergangs zwischen der Abdeckschicht voller Dicke und dem abgetragenen Bereich tritt nun ein stetiger, allmählicher Abfall in der Schichtdicke.

Die wesentlichen Schritte einer bevorzugten Ausführungsform des erfindungsgemässen Verfahrens sind in der Figurenfolge Fig. 2A -2D wiedergegeben. Das Aufbringen der Abdeckschicht 2 auf das Halbleitersubstrat 1 (Fig. 2A und 2B) erfolgt wie beim herkömmlichen Verfahren (Fig. 1A und 1B).

Wesentlich anders gestaltet sich jedoch der eigentliche Aetzprozess (Fig. 2C). Die an der Abdeckschicht 2 anliegende Maskenschicht 3 des herkömmlichen Verfahrens (Fig. 1C) ist nun, bei dem gezeigten Ausführungsbeispiel, durch eine mechanische Maske 4 ersetzt, die parallel zu der Abdeckschicht 2 in einem endlichen Maskenabstand A von der Abdeckschicht 2 angeordnet ist. Die mechanische Maske 4 kann beispielsweise eine Metallplatte mit entsprechenden Oeffnung sein.

Der Sinn des endlichen Maskenabstands A ist der folgende: Wird durch die mechanische Maske 4 hindurch die Abdeckschicht 2 mittels eines überwiegend anisotrop wirkenden Trockenätzprozesses abgetragen, überlagern sich eine anisotrope und eine nicht zu vermeidende isotrope Aetzkompnente.

In einem kernbereich direkt unterhalb der Maskenöffnung mit einer ersten Breite $B_1$ überwiegt die anisotrope, senkrecht gerichtete Komponente der Aetzung, die zu einem dem herkömmlichen Verfahren entsprechenden Abtrag der Abdeckschicht 2 in diesem Bereich führt.

Ausserhalb des Kernbereichs existiert jedoch ein zweiter grösserer Bereich mit einer zweiten Breite $B_2$, in dem die anisotrope Komponente abklingt und zunehmend durch eine isotrope Komponente überlagert wird. Diese Ueberlagerung hat einen neuen abgeschwächten Aetzangriff zur Folge, der als Resultat eine schräg abfallende Randkontur 5 (Fig. 2D) in der Abdeckschicht 2 hinterlässt, die den gewünschten keilförmigen Querschnitt aufweist.

Zur Beeinflussung des Aetzprofils, d.h. insbesondere der Breite des keilförmigen Uebergangsbereichs in der Abdeckschicht 2, stehen einerseits der Maskenabstand A, andererseits jedoch auch die Parameter des Trockenätzverfahrens selbst zur Verfügung.

Bevorzugt wird als Trockenätzverfahren ein Plasmaätzverfahren an sich bekannter Art verwendet (siehe z.B. L.M. Ephrath in J. Electrochem. Soc., Vol. 129, No.3 (1982), S. 62C ff.), bei welchem die Prozessparameter in geeigneter Weise so gewählt sind, dass die Aetzung überwiegend anisotrop wirkt. Hier kann das Aetzprofil beispielsweise durch den Druck des Aetzgases oder die Autopolarisationsspannung beeinflusst werden.

Bevorzugt wird eine Abdeckschicht 2 aus $SiO_2$ auf einem Halbleitersubstrat 1 aus Si verwendet. Die Aetzung wird dann mittels eines $SF_6$-Plasmas durchgeführt. Um in einer 1 $\mu$m dicken $SiO_2$-Schicht einen keilförmigen Randbereich von 1 mm Breite zu erzeugen, haben sich in der Praxis die folgenden Aetzbedingungen bewährt:    Aetzgas: $SF_6$

Druck: 20 $\mu$bar
Durchfluss: 5 sccm (Standard-ccm)
HF-Leistung: 150 W
Autopolari    sationsspannung: 800 V
Maskenabstand: 1 -10 mm

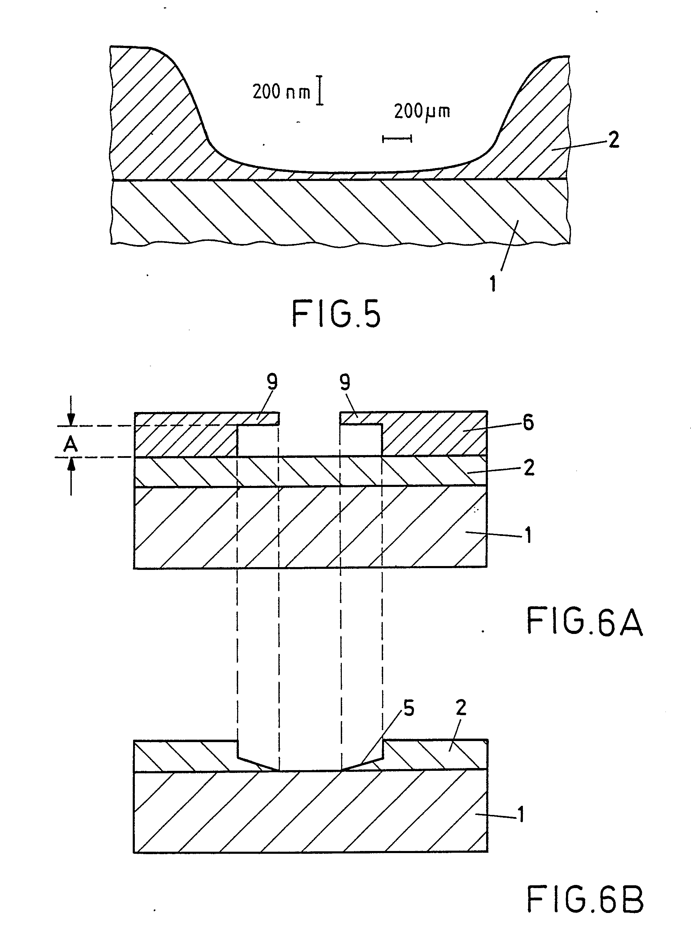

Das gemessene Aetztiefenprofil einer unter den o.g. Aetzbedingungen bei einem Maskenabstand A = 2 mm strukturierten $SiO_2$-Abdeckschicht ist in Fig. 5 wiedergegeben. Um die Verhältnisse im Randbereich zu verdeutlichen, ist bei dieser Darstellung der Massstab in Y-Richtung (Einheit: 200 nm) gegenüber dem Massstab in X-Richtung - (Einheit 200 $\mu$m) um den Faktor 1000 vergrössert gewählt.

Wird anstelle des $SiO_2$ die Abdeckschicht 2 gemäss einem weiteren Ausführungsbeispiel der Erfindung aus Photolack oder einem anderen Polymer gewählt, findet statt eines halogen-ein sauerstoffhaltiges Plasma Verwendung.

Weiterhin kann mit gleichem Erfolg eine Abdeckschicht 2 aus $Si_3N_4$ verwendet werden, die sich, wie die $SiO_2$-Schicht auch, in einem $SF_6$-Plasma in der gewünschten Weise abätzen lässt.

Ebenso ist die Aetzung nicht auf ein $SF_6$-Plasma oder ein sauerstoffhaltiges Plasma als Aetzplasma beschränkt. Vielmehr kann für das erfindungsgemässe Verfahren auch ein Plasma aus einer Mischung von Sauerstoff und einem halogenierten Kohlenwasserstoff, z.B. $CF_4$, verwendet werden.

Gute Ergebnisse lassen sich jedoch auch mit einem Halogengas-Plasma erzielen.

Ein anderes Ausführungsbeispiel des erfindungsgemässen Verfahrens soll anhand der Fig. 6A und 6B erläutert werden. An die Stelle der mechanischen Maske 4 aus Fig. 2C tritt in der Anordnung nach Fig. 6A eine Abdeckung 6, die zwar, wir beim herkömmlichen Verfahren gemäss Fig. 1C, an der Abdeckschicht 2 weitgehend anliegt, jedoch im Bereich der Aetzöffnung eine spezielle Ausgestaltung in Form eines am Rand der Aetzöffnung befindlichen Ueberhangs 9 aufweist. Die Abdeckung 6 kann dabei entweder eine anliegende mechanische Maske oder eine aufgebrachte Maskenschicht sein.

Dieser Ueberhang 9, der zwischen sich und der Oberfläche der Abdeckschicht 2 einen Raum freilässt und von der Abdeckschicht 2 wiederum einen endlichen Maskenabstand A einhält, erfüllt dieselbe Funktion wie die mechanische Maske 4 aus der Fig. 2C mit dem Unterschied, dass nunmehr die isotrope Aetzung unter der Maske seitlich begrenzt ist durch den Bereich, in dem die Abdeckung 6 an der Abdeckschicht 2 anliegt.

Mit der Anordnung gemäss Fig. 6A ergibt sich eine Abdeckschicht mit einer Randkontur, wie sie in Fig. 6B im Querschnitt dargestellt ist. Man erkennt deutlich, dass in diesem Fall der keilförmige Randbereich seitlich durch eine Stufe begrenzt ist. Auf diese Weise lassen sich geätzte Oeffnungen in der Abdeckschicht 2 erzeugen, die neben dem keilförmigen Randbereich zugleich eine definierte laterale Begrenzung aufweisen.

Insgesamt lassen sich nach der Erfindung auf besonders einfache Weise Abdeckschichten für die Halbleitertechnik erzeugen, die eine Randkontur mit keilförmigem Querschnitt besitzen, wobei durch einfache Aenderung der Prozessparameter die geometrischen Verhältnisse in der Randkontur in der erwünschten Weise beeinflusst werden können.

Die nach dem erfindungsgemässen Verfahren hergestellten Abdeckschichten lassen sich in der Halbleitertechnik in einem Bereich mit besonderem Vorteil verwenden, der sich mit der Herabsetzung der elektrischen Feldstärke im Gebiet eines an die Oberfläche tretenden P-N-Uebergangs befasst.

In der einen Verwendung dient der keilförmige Randbereich der Abdeckschicht als isolierende Unterlage für eine schräg liegende Feldplatte 7, die über dem an die Oberfläche tretenden P-N-Uebergang 10, der von einer Dotierungszone 8 und dem Halbleitersubstrat 1 gebildet wird, angeordnet ist - (Fig. 3). Durch Anlegen eines geeigneten Potentials an die Feldplatte 7 kann hier die Raumladungszone des P-N-Uebergangs 8 an der Oberfläche und damit die elektrische Feldstärke in bekannter Weise verändert werden.

In einer anderen Verwendung (Fig. 4) dient die Abdeckschicht 2 mit der keilförmigen Randkontur 5 als Implantationsmaske bei der Ionenplantation einer Dotierungszone 8 mit einem lateralen Dotierungsgradienten. Während die Implantation im Kernbereich der Oeffnung zu einer vollausgebildeten Dotierungszone führt, wird sie im keilfömigen Randbereich der Oeffnung mit zunehmender Dicke der Schicht zunehmend behindert, so dass in diesem Bereich ein lateraler Gradient entsteht, der die gewünschte Verbreiterung der Raumladungszone - (gestrichelt in Fig. 4 angedeutet) zur Folge hat.

Neben der Verwendung der Abdeckschicht 2 mit keilförmiger Randkontur 5 als Implantationsmaske bei der Ioenenimplantation, lässt sich diese Art der Maskierung in gleicher Weise auch bei allen anderen maskierten Dotierungsverfahren, z.B. der Diffusion aus der Gasphase, mit Erfolg verwenden, sofern die Maskierung mit SiO2-oder Si3N4-Schichten erfolgen kann.

Somit ermöglicht die nach der Erfindung hergestellte Abdeckschicht den Aufbau von Halbleiterbauelementen mit verbesserten Sperreigenschaften auf sehr einfache Weise, ohne dass auf technologisch aufwendige Masken oder Strukturierungsverfahren zurückgegriffen werden muss.

**Ansprüche**

1. Verfahren zum Herstellen einer in der Halbleitertechnik einsetzbaren Abdeckschicht, welche eine Randkontur mit einem keilförmigen Querschnitt aufweist, dadurch gekennzeichnet, dass auf einem Halbleitersubstrat (1) zunächst eine gleichmässige Abdeckschicht (2) erzeugt wird, dass dann eine Maske mit einer Oeffnung, deren Randkontur der zu erzeugenden Randkontur der Abdeckschicht (2) entspricht, in einem endlichen Maskenabstand (A) von der Abdeckschicht (2) angeordnet wird, und dass durch die Maskenöffnung hindurch die Abdeckschicht (2) mittels eines überwiegend anisotrop wirkenden Trockenätzverfahrens abgetragen wird.

2. Verfahren nach Anspruch 1, dadurch gekennzeichnet, dass das Trockenätzverfahren ein Plasmaätzverfahren ist, und die Parameter dieses Plasmaätzverfahrens so gewählt werden, dass der Aetzprozess überwiegend anisotrop verläuft.

3. Verfahren nach Anspruch 2, dadurch gekennzeichnet, dass die Abdeckschicht (2) aus SiO2 oder Si3N4 besteht und für die Aetzung ein SF6-Plasma verwendet wird.

4. Verfahren nach Anspruch 2, dadurch gekennzeichnet, dass die Abdeckschicht (2) aus Photolack oder einem anderen Polymer besteht und für die Aetzung ein sauerstoffhaltiges Plasma verwendet wird.

5. Verfahren nach Anspruch 3, dadurch gekennzeichnet, dass bei einem Druck von etwa 20 µbar, einem Gasdurchfluss von etwa 5 Standard-ccm, einer HF-Leistung von etwa 150 W und einer Autopolarisationsspannung von etwa 800 V die Aetzung durchgeführt wird.

6. Verfahren nach Anspruch 2, dadurch gekennzeichnet, dass für die Aetzung ein Plasma aus einer Mischung und einem halogenierten Kohlenwasserstoff verwendet wird.

7. Verfahren nach Anspruch 2, dadurch gekennzeichnet, dass für die Aetzung ein Halogengas-Plasma verwendet wird.

8. Verfahren nach Anspruch 1, dadurch gekennzeichnet, dass der Maskenabstand (A) im Bereich zwischen 1 bis 10 mm gewählt wird.

9. Verfahren nach Anspruch 1, dadurch gekennzeichnet, dass als Maske (4) eine mechanische Maske verwendet wird, die über der gesamten Maskenfläche von der Abdeckschicht (2) den Maskenabstand (A) einhält.

10. Verfahren nach Anspruch 1, dadurch gekennzeichnet, dass als Maske ein von der Abdeckschicht (2) um den Maskenabstand (A) entfernter Ueberhang (9) in der Oeffnung einer an der Abdeckschicht (2) anliegenden Abdeckung (6) verwendet wird.

11. Verwendung einer mit dem Verfahren nach Anspruch 1 hergestellten Abdeckschicht als isolierende Unterlage für eine schräg liegende Feldplatte (7) im Randbereich eines planaren, hochsperrenden P-N-Uebergangs (10).

12. Verwendung einer mit dem Verfahren nach Anspruch 1 hergestellten Abdeckschicht als Maske in einem maskierten Dotierungsprozess, insbesondere als Implantationsmaske bei der Ionenimplantation zur Erzeugung eines lateralen Dotierungsgradienten im Randbereich eines planaren, hochsperrenden P-N-Uebergangs (10).

FIG.1A

FIG.2A

FIG.1B

FIG.2B

FIG.1C

FIG.2C

FIG.1D

FIG.2D

FIG.3

FIG.4

FIG.5

FIG.6A

FIG.6B

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | EP-A-0 001 038  (IBM)<br><br>* Seite 6, Zeilen 1-13; Seite 8, Zeilen 21-27; Seite 14, Zeile 25 - Seite 15, Zeile 13; Seite 16, Zeile 15 - Seite 17, Zeile 18; Figur 6 * | 1,2,6-10 | H 01 L  21/00 |
| A | EXTENDED ABSTRACTS OF THE JOURNAL OF THE ELECTROCHEMICAL SOCIETY, vol. 80-1, Mai 1980, Seiten 289,290, Princeton; L.B. ROTHMAN et al.: "Process for forming tapered vias in SiO2 by reactive ion etching" *. Seite 289, Absatz * | 1 | |
| A | IBM TECHNICAL DISCLOSURE BULLETIN, Band 22, Nr. 7, Dezember 1979, Seiten 2737-2738, IBM, New York, US; W.W. KOSTE et al.: "Via profiling by plasma etching with varying ion energy" * Figuren 1,2 * | 1 | RECHERCHIERTE SACHGEBIETE (Int. Cl.4)<br><br>H 01 L |
| A | US-A-4 484 978  (FAIRCHILD) * Spalte 4, Zeilen 44-47 * | 1 | |
| A | US-A-4 461 672  (TEXAS INSTRUMENTS) * Spalte 3, Zeilen 56-62 * | 1,8 | |

Der vorliegende Recherchenbericht wurde für alle Patentansprüche erstellt.

| Recherchenort | Abschlußdatum der Recherche | Prüfer |
|---|---|---|
| DEN HAAG | 15-06-1987 | VANCRAEYNEST F.H. |